# EUROPEAN PATENT APPLICATION

(11) **EP 1 826 651 A1**
(43) Date of publication of application: **29.08.2007**
(21) Application number: 07009861.1
(22) Date of filing: 06.05.2005
(51) Int. Cl.: G05F 1/56

(54) **Internal voltage generator scheme and power management method**

(30) Priority: 14.05.2004 US 571063 P
(62) Divisional of application: 05746360.6
(71) Applicant: ZMOS TECHNOLOGY, INC., Sunnyvale, CA 94085 (US)
(72) Inventor: Choi, Myung Chan, San Jose, CA 95148 (US)
(74) Representative: Ebner von Eschenbach, Jennifer

(57) **Abstract**

An apparatus for generating a voltage on an internal voltage supply line within an integrated circuit from an external supply voltage, comprising: a current driver, said current driver having a gate, said current driver configured for passing a desired level of current between an external power supply input and at least one internal power supply line for an integrated circuit; wherein said current driver is configured with a switching threshold at or outside of a range of voltages available on said internal voltage supply line; and means for modulating gate voltage of said current driver to control switching state in response to power needs detected on said internal voltage supply line for an operating mode of the integrated circuit.

## Description

### CROSS-REFERENCE TO RELATED APPLICATIONS

This application claims priority from U.S. provisional application serial number 60/571,063 filed on May 14, 2004, incorporated herein by reference in its entirety.

### STATEMENT REGARDING FEDERALLY SPONSORED RESEARCH

### OR DEVELOPMENT

Not Applicable

### INCORPORATION-BY-REFERENCE OF MATERIAL

### SUBMITTED ON A COMPACT DISC

Not Applicable

### NOTICE OF MATERIAL SUBJECT TO COPYRIGHT PROTECTION

A portion of the material in this patent document is subject to copyright protection under the copyright laws of the United States and of other countries. The owner of the copyright rights has no objection to the facsimile reproduction by anyone of the patent document or the patent disclosure, as it appears in the United States Patent and Trademark Office publicly available file or records, but otherwise reserves all copyright rights whatsoever. The copyright owner does not hereby waive any of its rights to have this patent document maintained in secrecy, including without limitation its rights pursuant to 37 C.F.R. § 1.14.

### BACKGROUND OF THE INVENTION

### 1. Field of the Invention

This invention pertains generally to integrated circuits, and more particularly to internal voltage converters within integrated circuits.

### 2. Description of Related Art

The internal voltage converter (IVC) is widely used in VLSI design to control the operating voltage of the chip for reliability and power reduction. The operating voltage is controlled on an internal voltage supply line within the integrated circuit from an external supply voltage.

It will be recognized that smaller integrated circuit device geometries provide increased circuit density and reduced power consumption. However, these device can be constrained to operate at lower voltages, or are at least preferably operated at reduced voltage levels to reduce power dissipation. For example consider the case when the external system voltage is 3.3V with an integrated circuit fabricated with 0.13 *µm* technology whose maximum voltage (to guarantee device reliability) is less than 3.3V. In this case the operating voltage for the chip should be lowered below 3.3V, while it still must interface with devices operating at the external system voltage. It should be appreciated that lowering the voltage for the chip allows reducing the power consumption accordingly. By way of example, dropping the internal operating voltage from 3.3V to 1.3V can result in lowering power consumption by approximately 60%.

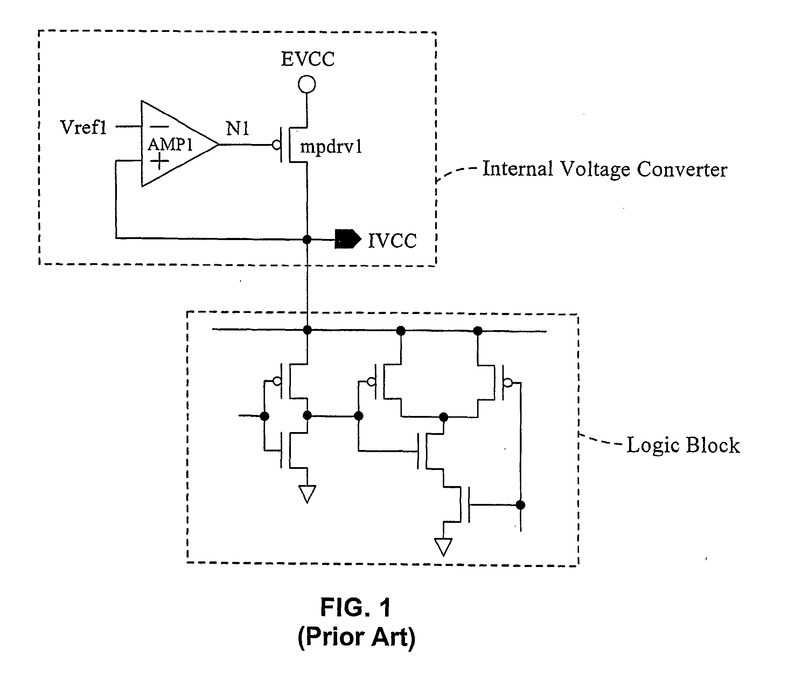

In these cases an internal voltage converter (IVC) provides a mechanism for generating the required internal voltage, such as depicted by the conventional IVC scheme of FIG. 1. The conventional IVC scheme is composed of the driver *(mpdrv1),* the error detector (AMP1) and a reference voltage (V_{ref1}) to control the level of the internal voltage (IV_{CC}).

External voltage (EV_{cc}) provides the power for the IVC and is typically a higher voltage than the internal voltage (IV_{cc}) generated by the IVC, and couples to the source of the IVC. The generated voltage IV_{CC} couples to the source of logic circuits within the logic block in FIG. 1 to supply the current for circuit operation. The IVC level is determined by a reference voltage (V_{ref1}). As the IV_{cc} level starts exceeding V_{ref1}, the voltage of node N1 rapidly increases toward turning off driver *mpdrv1* to reduce the current flowing from the external source (EV_{cc}) to the internal source (IV_{cc}). After some cycles of circuit operations, when IV_{cc} level decreases and is lower than V_{ref1}, the voltage of node N1 decreases to turn on the driver to recover the lowered level. Having the driver in the feedback loop therefore maintains internal voltage (IV_{CC}) in relation to the reference voltage V_{ref1}.

However, the conventional IVC scheme shown in FIG. 1 suffers from a number of shortcomings. The first shortcoming is a susceptibility to a power noise when electrical noise exists at EV_{CC}. Since EV_{CC} is a source of the PMOS driver *mpdrv1,* the noise at the power source is transferred directly to IV_{CC} wherein the voltage IV_{CC} is output in response to the variation of EV_{CC}. A second shortcoming is the leakage current that exists in the deep power-down modes. Even though PMOS driver *mpdrv1* is off, the leakage current flowing through it is not negligible and represents a large portion of the total leakage current when the device is in deep power-down mode.

Accordingly, a need exists for an internal voltage converter which can efficiently support a different internal voltage for the device without being subject to the noise and leakage problems of conventional IVC implementations.

### BRIEF SUMMARY OF THE INVENTION

Internal voltage converters (IVCs) are described which can be implemented within a variety of integrated circuits to provide a stable internal voltage with improved noise immunity and reduced power-down leakage, in particular at stand-by, or in power-down operating modes. The IVCs are implemented using current drivers comprising FET transistors, such as depletion and/or enhancement mode MOSFETs, and is well suited for use with NMOS pass transistors. It should be appreciated that the apparatus and method amenable to embodiment with a wide variety of transistors, and are not limited to use with specific types of transistors.

Internal voltage converters are described in general while a number of specific IVC embodiments are also taught. By way of example and not limitation, IVCs are taught which use analog control of switching, such as with an operational amplifier (or less preferably a form of comparator or discriminator) as well as IVCs which singly or in combination switch parallel pass transistors according to the operating mode. Two general types of IVC are also described, a standby IVC (SIVC) and an active IVC (AIVC). Standby IVCs (SIVCs) switch on after chip power is on and the chip is in the standby mode in order to maintain the IV_{CC} level. By contrast active IVCs (AIVCs) are activated during chip operation to maintain IV_{cc}.

The IVC devices generally comprise at least one pass element which is controlled in response to detected power needs, such as detected on one or more internal voltage supply lines, or in response to operating mode. In one set of embodiments the power needs are detected by a voltage error detector. Another set of embodiments determines the power needs based on the operating mode of the integrated circuit device, wherein it activates current drivers singly or in combination. Within the present invention the structure and configuration of the means for detecting the power needs and the current drivers are unique and provide a number of benefits in relation to conventional IVC devices.

The invention is amenable to being embodied in a number of ways, including but not limited to the following. One embodiment of the invention can be generally described as an apparatus for generating an internal voltage supply line within an integrated circuit from an external supply voltage, comprising: (a) a current driver passing a desired level of current between an external power supply input and at least one internal power supply line for an integrated circuit; (b) wherein the current driver is configured with a switching threshold at or more preferably outside of the range of voltages available on the internal voltage supply line; and (c) means for modulating the gate voltage of the current driver to control the switching state in response to power needs detected on the internal voltage supply line for the operating mode of the integrated circuit (e.g., active, stand-by, power-down, deep power-down).

The current driver, or drivers, may comprise any FET transistor, or transistor circuit. NMOS depletion or enhancement mode transistors are used according to one preferred embodiment to reduce leakage currents and increase noise immunity, in part due to their smaller footprint. It should also be noted that by driving the transistors with voltages at, or more preferably outside of the range of the internal voltage supply lines that both noise and leakage are reduced.

In one embodiment the means for modulating the gate voltage comprises an error detector circuit configured for detecting voltage errors on the internal voltage supply line in relation to a reference voltage. The error detector circuit preferably comprises an operational amplifier, or similar. In another embodiment multiple parallel current paths are provided and their activation and deactivation controlled singly or in combination according to the operating mode of the integrated circuit. In this embodiment the current driver(s) comprise at least two parallel transistor circuits (i.e., capable of switching different levels of current), and the means for modulating gate voltage comprises logic for activating singly, or in combination, the parallel transistor circuits for supplying the internal voltage supply. It should also be appreciated that the above two approaches can be combined in one circuit, wherein parallel current drivers are controlled singly or in combination with an analog feedback signal. Overall, it should be appreciated that that aspects of the described embodiments can be implemented singly, or in combination with one another, and/or in combination with what is known to one of ordinary skill in the art without departing from the teachings of the present invention.

It is preferred in these embodiments that the external supply voltage exceeds the internal supply voltage by an amount equal to or exceeding the threshold voltage of the current driver circuit (i.e., single MOSFET transistor such as NMOS or PMOS transistor). The current drivers are driven by a voltage range equal to or exceeding the internal voltage source range, or more preferably to a voltage range that is at or exceeding the external supply voltage range. Embodiments describe controlling a single internal voltage supply line, opposing positive and negative supply lines, multiple internal voltage supply lines (positive and/or negative), wherein a wide range of integrated circuit applications can be supported.

An additional power control circuit can be coupled to control the activity of the current drivers in response to the operating mode of the integrated circuit, such as when entering standby or power-down modes.

An embodiment of the invention can also be described as an apparatus for generating an internal supply voltage within an integrated circuit from an external supply voltage, comprising: (a) a current driver coupled between an external power supply and an internal supply line of an integrated circuit; (b) wherein the current driver is configured with a switching threshold at or outside of the range of voltages available on the internal supply line; and (c) an error detector configured for modulating the gate voltage of the current driver in response to voltage errors detected between the internal voltage supply line and a reference voltage. It should be appreciated that the internal voltage is preferably compared directly with the reference voltage, although it may be compared to a scaled and/or offset version of the reference voltage. Consequently, the present invention does not limit how the comparisons are made against the reference voltage for providing switching feedback.

The error detector (i.e., operational amplifier) is configured with an output voltage swing sufficiently outside of the range of voltages available on the internal supply line to control the switching of the current driver. Additional circuits can be incorporated to modulate the gate voltage of the current driver(s) in response to the operating mode of the integrated circuit. These circuits can alter, or switch, the level of current through the current driver(s) and provide for shutting down (deactivating) unnecessary circuits in response to stand-by, deep power-down modes, and so forth.

An embodiment of the invention can also be described as an apparatus for controlling internal voltage supplies within an integrated circuit configured for operating in different power modes, comprising: (a) multiple parallel switching devices supplying current to one or more internal voltage supply lines for the integrated circuit; (b) wherein the parallel switching devices are configured to have different current drive capabilities; and (c) a switching device driver coupled to each of the switching devices and configured to control the activation of each switching device in response to power modes within the integrated circuit.

At least a portion of the parallel switching devices in this embodiment are configured with a switching threshold at or outside of the range of the internal voltage supply lines. The multiple parallel switching devices comprise parallel transistors coupled for providing current to each of multiple positive, multiple negative, positive and negative, or multiple positive and negative internal voltage supply lines. The switching device driver is configured for activating selected parallel switching devices to supply current on one or more of the internal voltage supply lines in response to the operating modes (e.g., active, stand-by, and deep power down) of the integrated circuit.

An embodiment of the invention can also be described as a method of generating internal voltages for an integrated circuit, comprising: (a) coupling at least one current pass transistor having a threshold voltage at or outside of the range of voltage being supplied on an internal voltage supply line to a circuit device; (b) detecting power needs on the internal voltage supply line for the present operating mode of the integrated circuit; (c) driving the switching state of the current drive (pass) transistor in response to the detected power needs on the internal voltage supply line; and (d) wherein the current drive transistor is either activated or switched off by driving its gate with a voltage outside of the range of the internal voltage supply lines.

The detecting of power needs, according to one embodiment, comprises detecting voltage error on the internal voltage supply line in comparison with a reference voltage. The switching states are then driven by this feedback to maintain a desired voltage level on the internal voltage supply line. In another embodiment detecting of power needs comprises activating select current pass transistors in response to the operating mode of the integrated circuit. In either embodiment the switching threshold of the current drivers is preferably at or more preferably outside of the voltage range of the internal voltage supply lines, wherein the control circuits must generate control voltage outside of the internal supply voltage range. In these embodiments the switching state of the current drivers can be changed in response to power mode selections within the integrated circuit.

An embodiment of the invention can also be described as a method of generating voltage on internal voltage lines within an integrated circuit, comprising: (a) coupling multiple parallel current pass switches, configured for passing different levels of current, between external supply voltages and internal voltage supply lines within the integrated circuit; and (b) deactivating selected the pass switches in response to stand-by and power down modes within the integrated circuit.

The embodiment can further comprise supplying current through the current pass switches for both positive and negative internal voltage supply lines, while multiple positive internal voltage supply lines, multiple negative internal voltage supply lines, or multiple positive and negative internal voltage supply lines are also readily supported.

Described within the application are a number of beneficial inventive aspects, including but not necessarily limited to the following.

An aspect of the invention is an internal voltage converter (IVC) using an NMOS transistor driven by an error detector circuit.

Another aspect of the invention is an IVC that supports active and/or stand-by voltage conversion.

Another aspect of the invention is an IVC using either an enhancement or depletion mode NMOS transistor, or transistors.

Another aspect of the invention is an IVC using an NMOS transistor, or transistors, with an external voltage, or boosted voltage, which compensates for the drop across the pass element of the IVC, such as an NMOS transistor.

Another aspect of the invention is an IVC configured for having its error detector shut down in response to circuit operating mode, such as in response to entering a standby or shut-down state.

Another aspect of the invention is an IVC configured with a pass element that is controlled by an error detector within a first set of circuit modes, and controlled by circuit signals other than from the error detector in a second set of circuit modes.

Another aspect of the invention is an IVC having an NMOS driver, current passing device, configured with a gate whose voltage is boosted to provide an internal voltage level without a voltage threshold drop problem in active mode and subject to being self-reverse biased in another mode.

Another aspect of the invention is a power control apparatus which utilizes power pass elements having different characteristics according to the operating mode of the device.

A still further aspect of the invention is a method of controlling voltages generated within a device in response to operating mode.

Further aspects of the invention will be brought out in the following portions of the specification, wherein the detailed description is for the purpose of fully disclosing preferred embodiments of the invention without placing limitations thereon.

### BRIEF DESCRIPTION OF THE SEVERAL VIEWS OF THE DRAWING(S)

The invention will be more fully understood by reference to the following drawings which are for illustrative purposes only:

FIG. 1 is a schematic of a conventional internal V_{CC} converter (IVC) shown with the voltage converter section powering a logic block.

FIG. 2 is a schematic of an IVC generator according to an embodiment of the present invention shown for actively converting the voltage in response to control logic inputs.

FIG. 3 is a schematic of a standby IVC (SIVC) generator (Type 1) according to an embodiment of the present invention.

FIG. 4 is a schematic of another standby IVC (SIVC) generator (Type 2) according to an embodiment of the present invention.

FIG. 5 is a schematic of a first type of power management according to an embodiment of the present invention.

FIG. 6 is a schematic of a second type power management according to an embodiment of the present invention.

### DETAILED DESCRIPTION OF THE INVENTION

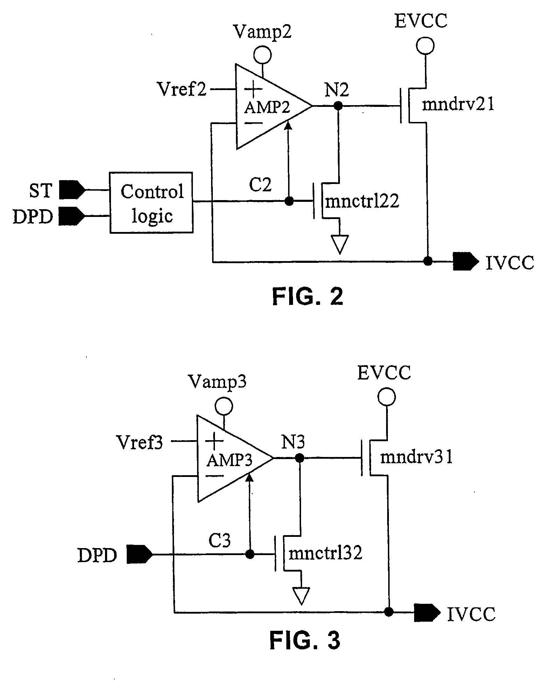

Referring more specifically to the drawings, for illustrative purposes the present invention is embodied in the apparatus generally shown in FIG. 2 through FIG. 6. It will be appreciated that the apparatus may vary as to configuration and as to details of the parts, and that the method may vary as to the specific steps and sequence, without departing from the basic concepts as disclosed herein.

1. Active IVC generator.

FIG. 2 illustrates by way of example, an IVC generator according to the invention having a current pass element which comprises an NMOS driver *(mndrv21)* instead of the conventional PMOS driver. This novel arrangement is somewhat counterintuitive and has not been adopted by the industry. However, this novel IVC generator circuit provides an ability to suppress noise effects at the power line as well as reducing leaking currents. The NMOS transistor in this embodiment can comprise a depletion or enhancement mode transistor, or transistors, depending on device process technology. Although a preferred configuration describes the use of a single NMOS driver transistor, it should be appreciated that multiple elements may be utilized. A device *(mnctrl22)* is configured for controlling the NMOS driver, such as coupled to the gate input of the NMOS driver. The error detector AMP2 is coupled to the driver and controlled according to the operating modes and applications for the device. It should be noted that the error detector is configured in this embodiment with a reverse sense in relation to the conventional PMOS driver.

In a normal mode, the new IVC operates in a similar manner as the conventional scheme shown in FIG. 1. When the internal (IV_{CC}) voltage level is higher than v_{ref2} the voltage of node N2 decreases toward turning off the driver to reduce the current from the external power to the internal power. When the IV_{CC} level is lower than a v_{ref2}, the voltage of node N2 increases toward turning on the driver thereby increasing the current flow from external power to internal power.

According to circuit applications, the IVC can be generally classified into at least two modes. One is referred to herein as standby IVC (SIVC) generation and the other as active IVC (AIVC) generation. SIVC is turned on after the chip power is on and the chip is in standby mode and configured for maintaining the IV_{CC} level within this substantially static mode of operation. AIVC is turned on when necessary during the active operation of the chip to maintain IV_{cc} level despite heavier current requirements which are typically more dynamic in nature. Therefore, both the static and active voltage conversions in the SIVC and AIVC have to be properly controlled in response to the given operating mode of the device. Therefore, AIVC shown in FIG. 2 needs to be turned off in both standby and deep power down mode while SIVC is only turned off when in deep power-down mode.

AIVC is preferably controlled by operating mode signals, such as exemplified by stand-by (ST) and deep power-down (DPD) as depicted in the figure. In a preferred embodiment, the error detector controlling the NMOS driver is configured to supply a voltage sufficiently higher than the internal voltage (IV_{cc}) to overcome the Vₜ drop due to use of the NMOS transistor. For example, when EV_{CC} is 1.5V, a target IV_{cc} level is 1.2V and Vₜ of the NMOS transistor is 0.7V the gate voltage of *mndrv21,* i.e., the voltage of node N2 should be 1.9V (=1.2 + 0.7) to allow supplying 1.2V to the IV_{cc} node. If voltage EV_{CC} is significantly higher than voltage IV_{CC}, for example EV_{CC} at 3.3V, IV_{cc} at 1.2V and Vₜ being 0.7V, then EV_{cc} can be used for the source voltage of AMP2. If the voltage EV_{cc} is not sufficient, then another boosted voltage should be generated internally or provided from an external source.

In standby or deep power-down mode the NMOS driver can be turned off by another device, such as *mnctrl22.* In standby or deep power-down mode, the node C2 goes to high to turn on *mnctrl22,* the N2 node goes to V_{SS} and turn off the NMOS driver. In addition signal C2 is preferably utilized for turning off AMP2 to eliminate any power consumption. By pulling down the node N2 to V_{SS}, the V_{gs} of *mndrv21* is - V_{DD} (0 - V_{DD} = - V_{DD}), assuming that internal voltage level IV_{CC} is V_{DD} in the active mode, and the V_{gs} of a PMOS logic transistor is zero (e.g., considering the first PMOS transistor shown in the logic block in FIG. 1).

Since *mndrv21* receives a significantly stronger reverse-bias than the logic PMOS transistor, shown in the conventional IVC of FIG. 1, the leakage current through *mndrv21* is consequently far smaller than the leakage current of the PMOS logic transistor, wherein the IV_{cc} level decreases a bit. Therefore, the logic PMOS transistor also becomes reverse-biased. Thus, all transistors, including *mndrv21* and PMOS logic transistor become reverse-biased and the leakage current flowing through the NMOS driver, *mndrv21,* can be suppressed significantly compared to that of the conventional scheme. So, in the new IVC scheme using the NMOS driver leads to improving the power noise immunity while the use of a voltage higher than IV_{cc} can be achieved without any voltage drop issue in active mode and since both the NMOS driver and PMOS logic transistors are reverse-biased in standby and deep power-down modes the leakage current is suppressed significantly.

2. Standby IVC generator (Type 1).

FIG. 3 is an embodiment of a first type (Type 1) standby IVC generator (SIVC). It should be appreciated that the standby (SIVC) differs from the active (AIVC) circuit shown in FIG. 2. The SIVC generator should be turned on when the chip is in standby mode, wherein SIVC is controlled in response to a device power-down (DPD) control signal as shown in FIG. 3. It should be recognized that the SIVC may be alternatively controlled with similar signals, or a group of signals, relating to standby operation. In the embodiment of FIG. 3, when the chip is in standby mode AMP3 is turned-on to detect any voltage drop at the IVCC node and to recover its dropped level to a target level. However, the circuit is configured so that the NMOS driver as well as AMP3 are turned-off when the device is subject to a deep power-down mode.

3. Standby IVC generator (Type 2).

One issue with the new SIVC scheme illustrated in FIG. 3 is the power consumption of error detector AMP3 during standby mode. Since the voltage drop at the IV_{cc} level is detected and compared with V_{ref3} during the standby mode, AMP3 should is turned on and consuming power.

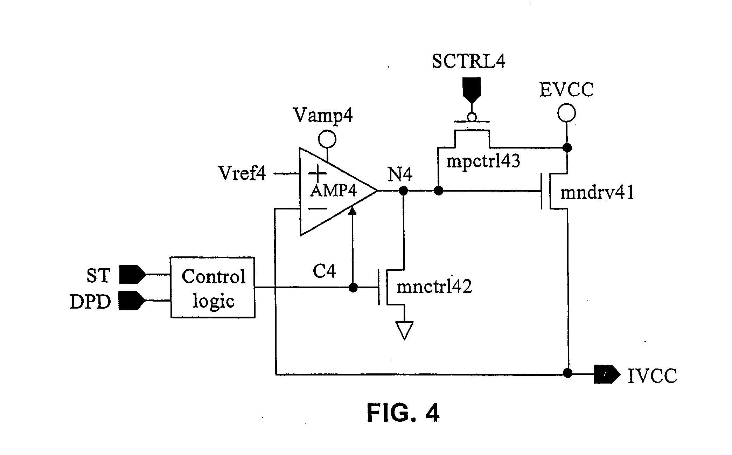

FIG. 4 illustrates a second type (Type 2) of SIVC which operates at reduced standby current levels. It can be seen in the figure that additional control circuits are shown coupled to the SIVC for controlling driver and AMP4 operation in both standby and deep power-down modes. It can be seen that in the deep power-down mode, the error detector AMP4 and the driver *mndrv41* are turned off as in the other IVC schemes in FIG. 2 and FIG. 3.

However, in FIG. 4 the configuration is different because AMP4 is turned off in standby mode and another switch means, such as *mpctrl43,* is activated to control the activity of the driver *mndrv41.* It should be appreciated that although transistor *mpctrl43* is depicted as a PMOS transistor, it can be replaced with an NMOS transistor. By turning on *mpctrl43* the IV_{CC} level can be made equal to EV_{CC} - Vₜₙ, where Vₜₙ is a threshold voltage of *mndrv41.* As a result, in this new SIVC circuit the power consumption of the error detector can be eliminated when in standby mode.

It should be recognized that these embodiments represent a new method of generating internal circuit device voltages from externally available voltages. A simple embodiment of this method could be described as an internal voltage generation method comprising: (a) coupling at least one current pass transistor having a threshold voltage at or outside of the range of voltage being supplied on an internal supply voltage line to a circuit device; (b) detecting voltage fluctuations on the internal supply voltage line; and (c) driving the gate of the current driver (pass transistor) in response to the voltage fluctuations (i.e., voltage error in relation with a reference voltage); wherein the gate drive can be at or outside of the range of voltage supplied to the circuit device.

In one embodiment an NMOS transistor replaces the PMOS transistor typically coupled from external V_{CC} (EV_{cc}) to internal V_{CC} (IV_{cc}) and is driven by a detector circuit having reversed sensing and at least one supply rail driven outside of the range provided by the internal supply voltage. In addition, at least one additional transistor can be coupled to the gate of the current pass transistor to modulate drive levels in response to the operating mode of the circuit device, such as stand-by and power-down modes. Furthermore, signals controlling the mode of the circuit device can select whether or not the error detector is activated. Still further, one or more additional transistors can be coupled to the driver, such as between the external power supply line and gate of the driver transistor, thereby controlling driver activity in response to an integrated circuit mode (i.e., stand-by or power-down) with the error detector shut down. It should be recognized that the apparatus and method is amenable to various modifications and can be practiced in a number of different ways which would be obvious to one of ordinary skill in the art and not limited to the embodiments exemplified in FIG. 2 through FIG. 4.

4. Power Management Types 1 and 2.

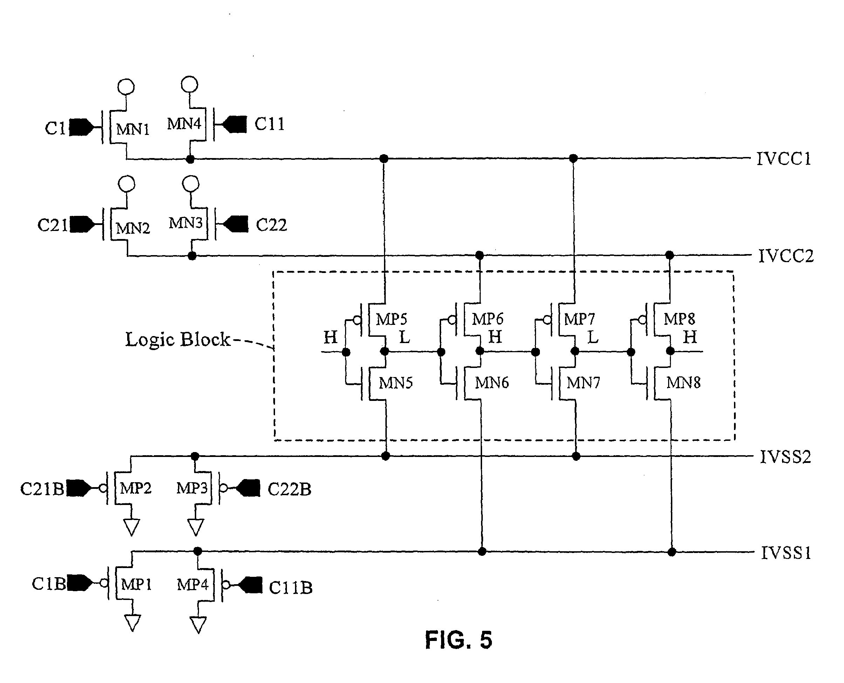

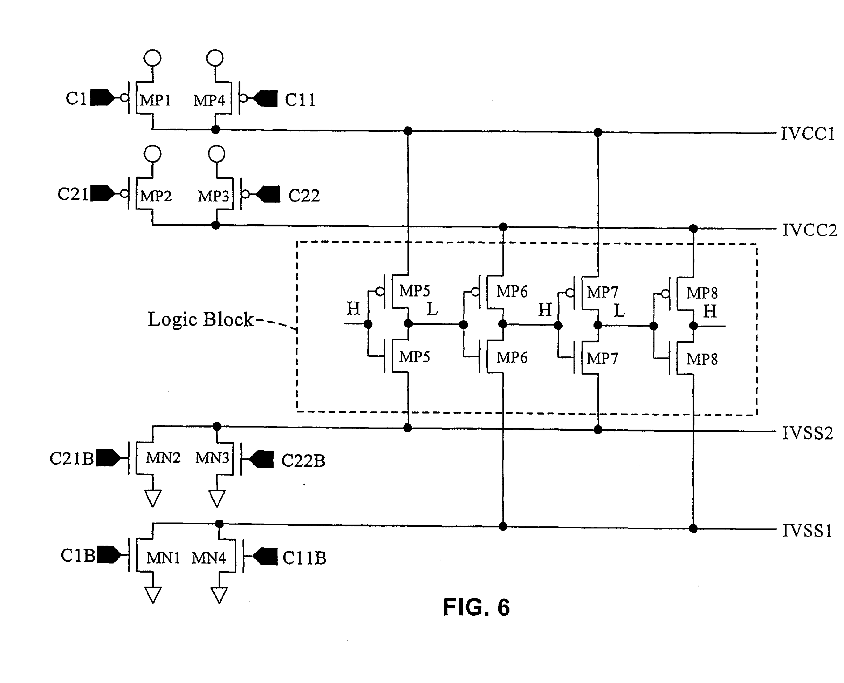

FIG. 5 and FIG. 6 represent power management mechanisms within integrated circuits which provide device power in a manner according to the specific operating mode of the device. In FIG. 5, transistors MN1, MN2, MN3 and MN4 control power received from the V_{DD} power source to two separate internal voltage supplies, while transistors MP1, MP2, MP3 and MP4 control V_{SS} power, respectively, from another two internal voltage supplies. It is preferable in this embodiment that transistors MN1, MP1, MN2 and MP2 are configured with higher current driving capacity than MN3, MP3, MN4 and MP4. In addition, only source transistors MN2 and MP2 are connected to IV_{cc2} and IV_{SS2}, respectively with their gate voltages controlled to deliver V_{DD} and Vₛₛ power levels without degradation. The logic states in standby mode for the logic block are also shown in FIG. 5.

In active mode, all transistors, in this case MN1, MN2, MN3, MN4, MP1, MP2, MP3 and MP4 are active to allow the logic block to execute at its maximum speed. In standby mode transistors MN5, MP6, MN7 and MP8 are turned on to maintain logic states shown in FIG. 5. Therefore, transistors MN1, MN4, MP1 and MP4 are turned off. It should be appreciated that since only the state of the logic circuits needs to be maintained in standby mode, that transistors MN2 and MP2 can be turned off and only transistors MN3 and MP3 are kept active. In active standby-mode, the logic states depicted in FIG. 5 are reversed, wherein high becomes low and vice versa. Therefore, in active standby-mode transistors MP5, MN6, MP7 and MN8 are turned on. In this case, MN1 and MP1 are turned off and small transistors, such as MN4 and MP4 can be turned on to suppress leakage current. The operation of these transistors can be controlled by a number of control signals depicted as C1, C1 B, C11, C11 B, C21, C21B, C22 and C22B. It will be readily recognized that all source transistors can be turned off when the device enters deep power-down mode. The transistor characteristics and operation states for the embodiment of FIG. 5 are summarized in Table 1.

It should be appreciated that a number of alternatives to this power management mechanism and method can be implemented. For example different numbers and levels and types of transistors may be utilized without departing from the teachings of the present invention.

FIG. 6 illustrates an example embodiment of a logic circuit whose power is managed according to the invention in a similar manner as shown in FIG. 5, however each transistors device is shown replaced by its complement, specifically PMOS transistors are used for V_{DD} control with NMOS transistors utilized for V_{SS} control. The transistor characteristics and operation states for FIG. 6 are summarized in Table 2.

It should be recognized that these power management embodiments can be considered a new method of controlling internal circuit device voltages from externally available voltages. A simple embodiment of this method could be described as a circuit device power management method, comprising: (a) coupling multiple parallel current pass switches between external supply voltages and supply voltages internal to a circuit device; and (b) activating selected pass switches in response to the desired power modes of the circuit device. The multiple current pass switches are preferably fabricated in different sizes, structures or geometries for providing different current driving capability. According to one mode of the method the current pass switches are coupled between both positive and negative outputs of the external supply voltages and the internal supply voltages. This novel power management method is particularly well suited for use with integrated circuits configured for operating under different supply voltage conditions in response to their operating modes. One of ordinary skill in the art should recognize that the novel aspects of the apparatus and methods taught herein can be practiced in a wide variety of ways without departing from the invention. By way of example, the device circuit can operate in modes including standby and power-down modes and any desired variations thereof with internal circuitry responsive to power being supplied by any desired number of internal supply lines.

It should be understood that the extended operating power modes (i.e., beyond On and Off) of a device circuit, which have been exemplified as standby and power-down or deep power-down have been provided by way of example. The apparatus and method of the present invention can be practiced with a variety of power related modes regardless of what they are specifically referred to or to what extents they regulate the power dissipation and activity within the integrated circuit device.

Although the description above contains many details, these should not be construed as limiting the scope of the invention but as merely providing illustrations of some of the presently preferred embodiments of this invention. Therefore, it will be appreciated that the scope of the present invention fully encompasses other embodiments which may become obvious to those skilled in the art, and that the scope of the present invention is accordingly to be limited by nothing other than the appended claims, in which reference to an element in the singular is not intended to mean "one and only one" unless explicitly so stated, but rather "one or more." All structural and functional equivalents to the elements of the above-described preferred embodiment that are known to those of ordinary skill in the art are expressly incorporated herein by reference and are intended to be encompassed by the present claims. Moreover, it is not necessary for a device or method to address each and every problem sought to be solved by the present invention, for it to be encompassed by the present claims. Furthermore, no element, component, or method step in the present disclosure is intended to be dedicated to the public regardless of whether the element, component, or method step is explicitly recited in the claims. No claim element herein is to be construed under the provisions of 35 U.S.C. 112, sixth paragraph, unless the element is expressly recited using the phrase "means for."

**Table 1**

| Transistor Characteristics and Operation States (type 1) | | | | | |
|---|---|---|---|---|---|
| | **Size** | **Active** | **Standby** | **Active- Standby** | **Deep Power-down** |
| **MN1** | Large | On | Off | Off | Off |
| **MN2** | Large | On | Off | Off | Off |
| **MN3** | Small | On | On | On/Off | Off |
| **MN4** | Small | On | Off | On/Off | Off |
| **MP1** | Large | On | Off | Off | Off |
| **MP2** | Large | On | Off | Off | Off |
| **MP3** | Small | On | On | On/Off | Off |
| **MP4** | Small | On | Off | On/Off | Off |

**Table 2**

| Transistor Characteristics and Operation States (type 2) | | | | | |
|---|---|---|---|---|---|
| | **Size** | **Active** | **Standby** | **Active- Standby** | **Deep Power-down** |
| **MP1** | Large | On | Off | Off | Off |
| **MP2** | Large | On | Off | Off | Off |
| **MP3** | Small | On | On | On/Off | Off |
| **MP4** | Small | On | Off | On/Off | Off |
| **MN1** | Large | On | Off | Off | Off |
| **MN2** | Large | On | Off | Off | Off |
| **MN3** | Small | On | On | On/Off | Off |
| **MN4** | Small | On | Off | On/Off | Off |

Features of the parent application include:
1. An apparatus for generating a voltage on an internal voltage supply line within an integrated circuit from an external supply voltage, comprising:
   a current driver, said current driver having a gate, said current driver configured for passing a desired level of current between an external power supply input and at least one internal power supply line for an integrated circuit;
   wherein said current driver is configured with a switching threshold at or outside of a range of voltages available on said internal voltage supply line; and
   means for modulating gate voltage of said current driver to control switching state in response to power needs detected on said internal voltage supply line for an operating mode of the integrated circuit.
2. An apparatus as recited in feature 1, wherein said current driver comprises an NMOS depletion or enhancement mode transistor.
3. An apparatus as recited in feature 1:
   wherein said means for modulating gate voltage comprises an error detector circuit configured for detecting voltage errors on the internal voltage supply line in relation with a reference voltage; and
   wherein said error detector circuit comprises an operational amplifier.
4. An apparatus as recited in feature 1:
   wherein said current driver comprises at least two parallel transistor circuits; and
   wherein said means for modulating gate voltage comprises logic for activating singly, or in combination, said parallel transistor circuits for supplying said internal voltage supply.
5. An apparatus as recited in feature 4, wherein each of said parallel transistor circuits is configured to switch different levels of current to or from said internal voltage supply.
6. An apparatus as recited in feature 1, wherein said means for modulating is configured to supply a gate voltage which is outside of the range of voltages available on said internal voltage supply line by an amount equal to the threshold voltage of said current driver.
7. An apparatus as recited in feature 6:
   wherein the external supply voltage exceeds said internal supply voltage by an amount equal to or exceeding the threshold voltage of said current driver; and
   wherein the external supply voltage is coupled for supplying power to said means for driving said current driver.
8. An apparatus as recited in feature 6:
   wherein the external supply voltage does not exceed said internal supply voltage by an amount equal to or exceeding the threshold voltage of said current driver; and
   wherein an external, or internally generated, voltage source of sufficient voltage is coupled to said means for driving said current driver.
9. An apparatus as recited in feature 1, wherein said current driver is coupled between a positive external supply voltage to a positive internal supply voltage.
10. An apparatus as recited in feature 1, further comprising a power control circuit coupled to said current driver for modulating gate voltage in response to integrated circuit operating modes.
11. An apparatus as recited in feature 10, wherein said power control circuit comprises a transistor coupled to the gate of said current driver for modulating the gate voltage in response to standby or power-down modes.
12. An apparatus as recited in feature 10, wherein said power control circuit is configured for shutting down said means for modulating gate voltage in response to standby or power-down modes.
13. An apparatus for generating a voltage on an internal supply voltage line within an integrated circuit from an external supply voltage, comprising:
   a current driver, said current drive having a gate, said current driver coupled between an external power supply and an internal supply line of an integrated circuit;
   wherein said current driver is configured with a switching threshold at or outside of the range of voltages available on said internal supply line; and
   an error detector configured for modulating gate voltage of said current driver in response to voltage errors detected between said internal voltage supply line and a reference voltage.
14. An apparatus as recited in feature 13, wherein said error detector is configured with an output voltage swing sufficiently outside of the range of voltages available on said internal supply line to control the switching of said current driver.
15. An apparatus as recited in feature 14, wherein said error detector comprises an operational amplifier.
16. An apparatus as recited in feature 13, further comprising a circuit coupled to the gate of said current driver for modulating the gate voltage in response to the operating mode of the integrated circuit.
17. An apparatus as recited in feature 16, wherein said circuit comprises a transistor gated by operating mode control signals of the integrated circuit.
18. An apparatus as recited in feature 13, wherein said error detector is configured for deactivation in response to receiving a power down control signal from the integrated circuit.
19. An apparatus for controlling internal voltage supplies within an integrated circuit configured for operating in different power modes, comprising:
   multiple parallel switching devices configured for supplying current to one or more internal voltage supply lines for the integrated circuit;
   wherein said parallel switching devices are configured to have different current drive capabilities; and
   a switching device driver coupled to each of said switching devices and configured to control activation of each switching device in response to power modes within the integrated circuit.
20. An apparatus as recited in feature 19, wherein at least a portion of said parallel switching devices is configured with a switching threshold at or outside of the range of the internal voltage supply lines.
21. An apparatus as recited in feature 19, wherein said multiple parallel switching devices comprise parallel switching devices coupled for providing current to each of multiple positive, multiple negative, positive and negative, or multiple positive and negative internal voltage supply lines.
22. An apparatus as recited in feature 19, wherein said switching device driver is configured for activating selected parallel switching devices to supply current on one or more of said internal voltage supply lines in response to the operating modes of the integrated circuit.
23. An apparatus as recited in feature 22, wherein said operating modes are selected from the group of operating power modes consisting essentially of active, stand-by, and deep power down.
24. A method of generating internal voltages for an integrated circuit, comprising:
   coupling at least one current pass transistor having a threshold voltage at or outside of a range of voltage being supplied on an internal voltage supply line to a circuit device;
   detecting power needs on the internal voltage supply line for the operating mode of the integrated circuit; and
   driving the switching state of said current pass transistor in response to said detected power needs on said internal voltage supply line;
   wherein said current pass transistor is either activated or switched off by driving its gate with a voltage outside of the range of the internal voltage supply lines.
25. A method as recited in feature 24:
   wherein said detecting of power needs comprises detecting voltage error on the internal voltage supply line in comparison with a reference voltage; and
   wherein the switching state is driven to maintain a desired voltage level on said internal voltage supply line.
26. A method as recited in feature 24, wherein said detecting of power needs comprises activating select current pass transistors in response to the operating mode of the integrated circuit.
27. A method as recited in feature 24, wherein at least a portion of said parallel switching devices are configured with a switching threshold at or outside the range of the internal voltage supply lines.
28. A method as recited in feature 27, further comprising modulating the switching state of said current pass transistor in response to power mode changes within the integrated circuit.
29. A method as recited in feature 24, wherein said current pass transistor comprises an NMOS enhancement or depletion mode field effect transistor.
30. A method as recited in feature 24:
   wherein switching state of said current pass transistor is driven by an operational amplifier configured with at least one supply voltage outside of the range of said internal voltage supply lines; and
   wherein said operational amplifier is configured with inputs for sensing the voltage on one said internal voltage supply line and a reference voltage.
31. A method as recited in feature 30, further comprising deactivating said operational amplifier in response to entering a standby or power down mode of the integrated circuit.
32. A method of generating voltage on internal voltage lines within an integrated circuit, comprising:
   coupling multiple parallel current pass switches, configured for passing different levels of current, between external supply voltages and internal voltage supply lines within an integrated circuit; and
   deactivating selected of said current pass switches in response to stand-by and power down modes within the integrated circuit.
33. A method as recited in feature 32, further comprising supplying current through said current pass switches for both positive and negative internal voltage supply lines.
34. A method as recited in feature 32, further comprising supplying current through said current pass switches to multiple positive internal voltage supply lines, multiple negative internal voltage supply lines, or multiple positive and negative internal voltage supply lines.
35. A method as recited in feature 32, wherein the switching of at least a portion of said current pass switches are controlled by voltages which are outside of the voltage range provided by the internal voltage supply lines.
36. A method as recited in feature 32, wherein at least a portion of said integrated circuit is configured for operation from different internal voltage supply lines in response to changes in the operating power mode of said integrated circuit.
37. A method as recited in feature 32, wherein said current pass transistors are configured for passing different levels of current in response to being fabricated in different sizes, structures or geometries.

## Claims

1. An apparatus for generating a voltage on an internal voltage supply line within an integrated circuit from an external supply voltage, comprising: a current driver, said current driver having a gate, said current driver configured for passing a desired level of current between an external power supply input and at least one internal power supply line for an integrated circuit; wherein said current driver is configured with a switching threshold at or outside of a range of voltages available on said internal voltage supply line; and means for modulating gate voltage of said current driver to control switching state in response to power needs detected on said internal voltage supply line for an operating mode of the integrated circuit.

2. An apparatus as recited in claim 1, wherein said current driver comprises an NMOS depletion or enhancement mode transistor.

3. An apparatus as recited in claim 1: wherein said means for modulating gate voltage comprises an error detector circuit configured for detecting voltage errors on the internal voltage supply line in relation with a reference voltage; and wherein said error detector circuit comprises an operational amplifier.

4. An apparatus as recited in claim 1: wherein said current driver comprises at least two parallel transistor circuits; and wherein said means for modulating gate voltage comprises logic for activating singly, or in combination, said parallel transistor circuits for supplying said internal voltage supply.

5. An apparatus as recited in claim 4, wherein each of said parallel transistor circuits is configured to switch different levels of current to or from said internal voltage supply.

6. An apparatus as recited in claim 1, wherein said means for modulating is configured to supply a gate voltage which is outside of the range of voltages available on said internal voltage supply line by an amount equal to the threshold voltage of said current driver.

7. An apparatus as recited in claim 6, wherein:
the external supply voltage exceeds said internal supply voltage by an amount equal to or exceeding the threshold voltage of said current driver; and the external supply voltage is coupled for supplying power to said means for driving said current driver; or
the external supply voltage does not exceed said internal supply voltage by an amount equal to or exceeding the threshold voltage of said current driver; and an external, or internally generated, voltage source of sufficient voltage is coupled to said means for driving said current driver.

8. An apparatus as recited in claim 1, wherein said current driver is coupled between a positive external supply voltage and a positive internal supply voltage.

9. An apparatus as recited in claim 1, further comprising a power control circuit coupled to said current driver for modulating gate voltage in response to integrated circuit operating modes.

10. An apparatus as recited in claim 9, wherein:
said power control circuit comprises a transistor coupled to the gate of said current driver for modulating the gate voltage in response to standby or power-down modes; or
said power control circuit is configured for shutting down said means for modulating gate voltage in response to standby or power-down modes.

11. An apparatus for generating a voltage on an internal supply voltage line within an integrated circuit from an external supply voltage, comprising: a current driver, said current drive having a gate, said current driver coupled between an external power supply and an internal supply line of an integrated circuit; wherein said current driver is configured with a switching threshold at or outside of the range of voltages available on said internal supply line; and an error detector configured for modulating gate voltage of said current driver in response to voltage errors detected between said internal voltage supply line and a reference voltage.

12. An apparatus as recited in claim 11, wherein said error detector is configured with an output voltage swing sufficiently outside of the range of voltages available on said internal supply line to control the switching of said current driver.

13. An apparatus as recited in claim 12, wherein said error detector comprises an operational amplifier.

14. An apparatus as recited in claim 11, further comprising a circuit coupled to the gate of said current driver for modulating the gate voltage in response to the operating mode of the integrated circuit.

15. An apparatus as recited in claim 14, wherein said circuit comprises a transistor gated by operating mode control signals of the integrated circuit.

16. An apparatus as recited in claim 11, wherein said error detector is configured for deactivation in response to receiving a power down control signal from the integrated circuit.

17. An apparatus for controlling internal voltage supplies within an integrated circuit configured for operating in different power modes, comprising: multiple parallel switching devices configured for supplying current to one or more internal voltage supply lines for the integrated circuit; wherein said parallel switching devices are configured to have different current drive capabilities; and a switching device driver coupled to each of said switching devices and configured to control activation of each switching device in response to power modes within the integrated circuit

18. An apparatus as recited in claim 17, wherein:
at least a portion of said parallel switching devices is configured with a switching threshold at or outside of the range of the internal voltage supply lines; or
said multiple parallel switching devices comprise parallel switching devices coupled for providing current to each of multiple positive, multiple negative, positive and negative, or multiple positive and negative internal voltage supply lines.

19. An apparatus as recited in claim 17, wherein said switching device driver is configured for activating selected parallel switching devices to supply current on one or more of said internal voltage supply lines in response to the operating modes of the integrated circuit

20. An apparatus as recited in claim 19, wherein said operating modes are selected from the group of operating power modes consisting essentially of active, stand-by, and deep power down.

21. A method of generating internal voltages for an integrated circuit, comprising: coupling at least one current pass transistor having a threshold voltage at or outside of a range of voltage being supplied on an internal voltage supply line to a circuit device; detecting power needs on the internal voltage supply line for the operating mode of the integrated circuit; and driving the switching state of said current pass transistor in response to said detected power needs on said internal voltage supply line; wherein said current pass transistor is either activated or switched off by driving its gate with a voltage outside of the range of the internal voltage supply lines.

22. A method as recited in claim 21, wherein:
said detecting of power needs comprises detecting voltage error on the internal voltage supply line in comparison with a reference voltage; and
wherein the switching state is driven to maintain a desired voltage level on said internal voltage supply line; or said detecting of power needs comprises activating select current pass transistors in response to the operating mode of the integrated circuit.

23. A method as recited in claim 21, wherein at least a portion of said parallel switching devices are configured with a switching threshold at or outside the range of the internal voltage supply lines.

24. A method as recited in claim 23, further comprising modulating the switching state of said current pass transistor in response to power mode changes within the integrated circuit

25. A method as recited in daim 21, wherein said current pass transistor comprises an NMOS enhancement or depletion mode field effect transistor.

26. A method as recited in claim 21: wherein switching state of said current pass transistor is driven by an operational amplifier configured with at least one supply voltage outside of the range of said internal voltage supply lines; and wherein said operational amplifier is configured with inputs for sensing the voltage on one said internal voltage supply line and a reference voltage.

27. A method as recited in claim 26, further comprising deactivating said operational amplifier in response to entering a standby or power down mode of the integrated circuit.

28. A method of generating voltage on internal voltage lines within an integrated circuit, comprising: coupling multiple parallel current pass switches, configured for passing different levels of current, between external supply voltages and internal voltage supply lines within an integrated circuit; and deactivating selected of said current pass switches in response to standby and power down modes within the integrated circuit.

29. A method as recited in claim 28,
further comprising supplying current through said current pass switches for both positive and negative internal voltage supply lines; or
further comprising supplying current through said current pass switches to multiple positive internal voltage supply lines, multiple negative internal voltage supply lines, or multiple positive and negative internal voltage supply lines; or
wherein the switching of at least a portion of said current pass switches are controlled by voltages which are outside of the voltage range provided by the internal voltage supply lines; or
wherein at least a portion of said integrated circuit is configured for operation from different internal voltage supply lines in response to changes in the operating power mode of said integrated circuit; or
wherein said current pass transistors are configured for passing different levels of current in response to being fabricated in different sizes, structures or geometries.
